(19) Europäisches Patentamt
European Patent Office
Office européen des brevets

(11) EP 0 892 860 B1

(12) **EUROPÄISCHE PATENTSCHRIFT**

(45) Veröffentlichungstag und Bekanntmachung des Hinweises auf die Patenterteilung:
**09.07.2003 Patentblatt 2003/28**

(51) Int Cl.⁷: **C23C 14/34**, H01J 37/34

(21) Anmeldenummer: **97919358.8**

(22) Anmeldetag: **14.04.1997**

(86) Internationale Anmeldenummer:
**PCT/EP97/01871**

(87) Internationale Veröffentlichungsnummer:
**WO 97/039161 (23.10.1997 Gazette 1997/45)**

(54) **VORRICHTUNG ZUR KATHODENZERSTÄUBUNG**

CATHODIC SPUTTERING DEVICE

DISPOSITIF DE PULVERISATION CATHODIQUE

(84) Benannte Vertragsstaaten:
**CH DE FR GB LI NL SE**

(30) Priorität: **13.04.1996 DE 19614598**

(43) Veröffentlichungstag der Anmeldung:
**27.01.1999 Patentblatt 1999/04**

(73) Patentinhaber: **Singulus Technologies AG**
**63755 Alzenau (DE)**

(72) Erfinder: **SICHMANN, Eggo**
**D-63571 Gelnhausen (DE)**

(74) Vertreter: **VOSSIUS & PARTNER**
**Siebertstrasse 4**
**81675 München (DE)**

(56) Entgegenhaltungen:
**EP-A- 0 393 957          EP-A- 0 608 478**
**EP-A- 0 676 791          DE-A- 4 315 023**
**DE-U- 9 017 728**

Printed by Jouve, 75001 PARIS (FR)

**Beschreibung**

Die Erfindung bezieht sich auf eine Vorrichtung zur Kathodenzerstäubung für die Herstellung von Schichten auf einem Substrat mittels einer in einer Vakuumkammer einbringbaren Zerstäubungskathode, die mit Bezug auf die Mittelachse der Zerstäubungskathode konzentrisch angeordnete Magneten bzw. Ringmagneten, Polschuhe und ein Target aufweist und deren Oberfläche mit Bezug auf die Targetrückseite zumindest teilweise geneigt verläuft.

Es ist bereits eine Vorrichtung zur Kathodenzerstäubung für die statische Beschichtung scheibenförmiger Substrate mittels eines Plasmas in einer Vakuumkammer mit mindestens einer Öffnung bekannt (DE 43 15 023 A1), welche durch Auflegen einer Zerstäubungskathode von außen verschließbar ist. Zwischen der Kathode und der Kammerwand sind ein elastischer Vakuumdichtring sowie eine ringförmige Anode vorgesehen, die die Öffnungen radial von außen umgeben, wobei die Anode auf ihrer zur Kathode hin zeigenden Seite eine ebene Kontaktfläche aufweist. Die bekannte Zerstäubungskathode besteht aus einem scheibenförmigen, ferromagnetischen Joch und einer Kühlplatte. Zwischen beiden ist ein scheibenförmiger Isolator eingelegt. Vor der Kühlplatte befindet sich das zu zerstäubende Target, während auf der Rückseite der Kühlplatte in einer Nut ein Ringmagnet eingelegt ist. Durch den Ringmagneten wird ein Gegenmagnetfeld erzeugt, welches den Verlauf der Magnetfeldlinien beeinflußt. Hierdurch erhält der Verlauf der Magnetfeldlinien einen annähernd parallelen bzw. linsenförmigen oder konvexen Verlauf.

Die Vorrichtung weist ein Zerstäubungstarget auf, dessen Neufläche aus einer konisch nach innen verlaufenden Zylinderfläche besteht, die in einen zum Oberflächensubstrat parallelen Abschnitt übergeht.

Aus der EP-A-676 791 ist eine Magnetronzerstäubungsquelle bekannt Der Targetkörper weist eine konkave Zerstäubungsfläche auf, die den Prozeßraum begrenzt Die Targetneufläche weist die Form einer konisch nach innen verlaufenden Zylinderfläche auf oder hat die Form einer Kugelkalotte.

Aus der EP-A-608 478 ist eine weitere Vorrichtung zur Kathodenzerstäubung bekannt. Die Vorderseite des Zerstäubungstargets soll im wesentlichen dachförmig verlaufen. Die Dachform soll durch mindestens zwei oder drei Ebenen gebildet werden. Wie den Figuren zu entnehmen ist, besteht das Target aus einem radial innen liegenden ringförmigen Bereich, der parallel zur Substratoberfläche verläuft und einem sich diesem Bereich direkt anschließenden radial außen liegenden und nach innen geneigten Bereich.

EP-A-393 957 offenbart ein Magnetonsputterverfahren und eine entsprechende Vorrichtung. Die Neufläche des Targets besteht aus einem inneren Bereich, der parallel zur Substratoberfläche angeordnet ist und einem äußeren Bereich, der schräg nach außen verläuft.

Demgegenüber liegt der Erfindung die Aufgabe zugrunde, die Targetoberfläche derart anzuordnen oder zu gestalten, daß die Targetausbeute verbessert wird. Diese Aufgabe wird mit den Merkmalen der Patentansprüche gelöst.

Bei der Lösung dieser Aufgabe geht die Erfindung von dem Grundgedanken aus, eine bestimmte Targetgeometrie vorzusehen, die eine erhöhte Standzeit ermöglicht. Insbesondere hat das Target am Innen- und auch am Außenrand der Sputterfläche jeweils eine abgeschrägte Überhöhung, um den Elektroneneinschluß zu verbessern.

Gelöst wird die Aufgabe erfindungsgemäß dadurch, daß eine mit Bezug auf die Targetrückseite schräg verlaufende Targetoberfläche oder zumindest ein Teil dieser mit der Targetrückseite einen Winkel einschließt und die Targetoberfläche zwischen weiteren Targetoberflächen liegt, die mit der schräg verlaufenden Targetoberfläche ebenfalls einen Winkel einschließen. Hierdurch kann die Targetausbeute optimiert werden, da die Oberfläche des Targets eine den Magnetfeldlinien entsprechend angepaßten Verlauf aufweist. Dies wird auch dadurch erreicht, daß durch die vorteilhafte Ausgestaltung der Targetoberfläche die Magnetfeldlinien flach verlaufen. Durch die schräg verlaufende Fläche auf dem Target bzw. durch die konvexe Targetoberfläche wird eine Fokussierung des Materials von einem größeren Target auf ein kleines Substrat bewirkt. Durch den parallelen Verlauf der Teiltargetflächen wird eine Materialanhäufung für das Target zur Verfügung gestellt. Dabei ist es vorteilhaft, daß das Magnetfeld dieser Targetform angepaßt ist, d.h. annähernd parallel zur Targetoberfläche verläuft.

Dazu ist es vorteilhaft, daß die mit Bezug auf die Targetrückseite schräg verlaufende Targetoberfläche zwischen Targetoberflächen liegt, die mit ihr einen Winkel einschließen, der größer als 10° ist.

In weiterer Ausgestaltung der Erfindung ist es vorteilhaft, daß die mit Bezug auf die Targetrückseite schräg verlaufende Targetoberfläche zwischen Targetoberflächen liegt, die mit ihr einen Winkel einschließen, der zwischen 10° und 40° bzw. zwischen 15° und 40° bzw. zwischen 20° und 40° ist und daß sich an das innere Ende der schräg verlaufenden Targetoberfläche eine rotationssymmetrische Ringnut anschließt.

Gemäß einer bevorzugten Ausführungsform der erfindungsgemäßen Lösung ist schließlich vorgesehen, daß sich an das innere Ende der schräg verlaufenden Targetoberfläche eine rotationssymmetrische Ringnut bzw. V-förmige Ringnut anschließt, die einen Winkel zwischen 10° und 40° aufweist.

Von besonderer Bedeutung ist für die vorliegende Erfindung, daß das obere, sich im Bereich der Targetoberfläche befindliche Ende in ein nach außen gerichtetes Teil bzw. eine spitzförmige Nase übergeht.

Im Zusammenhang mit der erfindungsgemäßen Ausbildung und Anordnung ist es von Vorteil, daß die Nase einen Winkel einschließt, der zwischen 20° und 60° oder zwischen 25° und 55° oder zwischen 30° und 40° oder zwischen 38° und 44° groß sein kann.

Vorteilhaft ist es ferner, daß die V-förmige rotationssymmetrische Ringnut einen Winkel zwischen 30° und 50° einschließt.

Außerdem ist es vorteilhaft, daß der Randteil mit der Nase eine Breite aufweist, die kleiner ist als die Breite der parallel zur Targetrückseite verlaufenden Ringfläche bzw. kleiner als die Breite der geneigt verlaufenden Fläche.

Hierzu ist es vorteilhaft, daß die Breite $B_1$ in etwa doppelt so groß ist wie die Breite $B_2$ und doppelt so groß wie die Breite $B_3$.

Ferner ist es vorteilhaft, daß der Winkel zwischen der geneigt verlaufenden Oberfläche und der Targetvorderseite zwischen 18° und 34° oder zwischen 20° und 32° oder zwischen 23° und 29° oder auch 26° groß ist.

Vorteilhaft ist es auch, daß im Bereich der Targetrückseite neben dem ersten inneren Ringmagneten ein zweiter äußerer, im Durchmesser größerer Ringmagnet vorgesehen ist. Durch die Verwendung zweier Ringmagneten kann eine Verstärkung des Magnetfeldes und gleichzeitig in einem bestimmten Bereich der Kathode ein flacher Oberflächenverlauf der Magnetfeldlinien mit bezug zur Targetrückseite erreicht werden. Hierdurch wird eine noch bessere Targetausnutzung sichergestellt.

Hierzu ist es ferner vorteilhaft, daß die beiden im Bereich der Targetrückseite vorgesehenen Ringmagneten auf der gleichen Querebene angeordnet sind und daß der innere Ringmagnet im Bereich des Außenumfangs der Mittelmaske bzw. Mittelanode bzw. eines Kühlfingers und der äußere Ringmagnet im Randbereich bzw. im Bereich des Außenumfangs des Targets vorgesehen ist.

In weiterer Ausgestaltung der Erfindung ist es vorteilhaft, daß neben den beiden inneren Ringmagneten ein dritter, die beiden Ringmagneten umgebender Ringmagnet vorgesehen ist und daß der dritte Ringmagnet an eine Seite bzw. an die untere Seite des Joches angrenzt.

Gemäß einer bevorzugten Ausführungsform der erfindungsgemäßen Lösung ist schließlich vorgesehen, daß alle Ringmagneten rotationssymmetrisch mit Bezug auf die Mittelachse des Targets angeordnet sind und daß die beiden inneren Ringmagneten in sich in der Kühlplatte befindenden Ringnuten vorgesehen sind. Der seitlich angebrachte Ringmagnet, erzeugt das das Target durchdringende Magnetfeld.

Eine zusätzliche Möglichkeit ist gemäß einer Weiterbildung der erfindungsgemäßen Vorrichtung, daß der äußere Ringmagnet im Bereich des Polschuh-Durchmessers zwischen dem Joch und dem oberen Teil des Polschuhs vorgesehen ist und daß die beiden inneren Ringmagneten innerhalb des Außendurchmessers bzw. des Außenumfangs des Targets liegen.

Vorteilhaft ist es ferner, daß der äußere Ringmagnet einen größeren Abstand zur Targetrückseite aufweist als die beiden inneren Ringmagneten und daß ein vierter Ringmagnet vorgesehen ist, der den Außenumfang des Targets umgibt. Durch den Einbau der zusätzlichen Doppelringmagneten, die auch sehr dicht an die Targetrückseite herangebracht werden können, wird ein möglichst breiter Errcsionsgraben erzielt, da die Elektronen nicht auf enge Bereiche Fokussiert bzw. in einem engen Ringkanal fokussiert werden. Deshalb ist es vorteilhaft, daß man eine große horizontale Komponente des Magnetfeldes erreicht, und durch den Einbau der Doppelringmagneten in die Rückwand der Kühlplatte erhält man einen sehr geringen Abstand zur Targetrückseite. Von besonderer Bedeutung ist auch die Targetkonfiguration und die Polschuhausbildung.

Hierzu ist es vorteilhaft, daß die Dicke $D_1$ des Targets an seinem äußeren Randbereich größer ist als die Dicke $D_2$ im inneren Randbereich des Targets und daß zwischen dem inneren und dem äußeren Randbereich des Targets eine geneigt verlaufende Targetoberfläche und eine parallel zur Targetrückseite verlaufende Targetoberfläche vorgesehen ist.

Von Vorteil ist es ferner, daß die geneigt verlaufende Targetoberfläche im inneren Randbereich des Targets und die parallel verlaufende Targetoberfläche im äußeren Randbereich des Targets vorgesehen ist und daß die geneigt verlaufende Targetoberfläche und die parallel verlaufende Targetoberfläche zwischen einem inneren und einem äußeren, spitzförmig hervorstehenden Targetteil vorgesehen sind.

Eine zusätzliche Möglichkeit gemäß einer Weiterbildung der erfindungsgemäßen Vorrichtung besteht darin, daß am inneren Randbereich des Targets ein ringförmiges, konzentrisch zur Mittelachse verlaufendes Flanschteil vorgesehen ist, das zwischen der Oberfläche der Kühlplatte und dem Flanschteil eines Kühlfingers eingeklemmt ist, der mit dem Target fest bzw. lösbar verbunden ist. Durch die vorteilhafte Ausbildung des Targets mit einem flanschförmigen Teil in Verbindung mit einem einschraubbaren oder mittels Schraubenelementen feststellbaren Kühlfinger muß das Target nicht mehr aufgebonded, sondern kann nach Bedarf jederzeit ohne weiteres ausgewechselt werden.

Je nach Anwendungsfall ist es auch möglich, daß im Bereich des Außenumfangs des Targets mindestens ein Ringmagnet unterhalb der an der Targetrückseite bzw. in deren Bereich vorgesehenen Ringmagneten vorgesehen ist.

Hierzu ist es ferner vorteilhaft, daß der im Bereich des Außenumfangs des Targets vorgesehene Ringmagnet etwas oberhalb der unteren Begrenzung der Targetoberfläche vorgesehen ist und daß der im Bereich des Außenumfangs des Targets vorgesehene Ringmagnet etwas außerhalb der unteren Begrenzung der Targetoberfläche vorgesehen ist, die parallel zur Targetrückseite des Targets verläuft.

In weiterer Ausgestaltung der Erfindung ist es vorteilhaft, daß der im Bereich des Außenumfangs des Targets vorgesehene Ringmagnet etwas unterhalb oder außerhalb der unteren Begrenzung der Polschuhe endet, daß der Ringmagnet konzentrisch zur Mittelachse des Targets angeordnet ist und daß das untere Ende des Polschuhs einen größeren Abstand zur Targetrückseite aufweist als das untere Ende des Targets bzw. die Targetoberfläche.

Auf diese Weise wird erreicht, daß im unteren Bereich des Polschuhs ein Ringraum bzw. eine Kammer zur Aufnahme des äußeren Ringmagneten vorgesehen ist und daß der untere Teil des Polschuhs zum Außenumfang der Polschuhe aus einem sich pyramidenstumpfförmig verjüngenden Polschuhteil besteht.

Von besonderer Bedeutung ist für die vorliegende Erfindung, daß der sich pyramidenstumpfförmig verjüngende Polschuhteil in einen Flanschteil übergeht, der breiter ist als das freistehende Ende des Polschuhs, und daß der Flanschteil des Polschuhs die eine Kammerwand des Ringmagneten bildet.

Im Zusammenhang mit der erfindungsgemäßen Ausbildung und Anordnung ist es von Vorteil, daß zwischen der Stirnfläche des Endes des Polschuhs und der geneigt verlaufenden Seitenwand des sich pyramidenstumpfförmig verjüngenden Polschuhteils ein Winkel ($\alpha$) eingeschlossen ist, der zwischen 10° und 50° bzw. zwischen 25° und 45° groß ist.

Außerdem ist es vorteilhaft, daß der Abstand zwischen dem äußeren Ringmagneten und dem unteren Ende bzw. der Stirnfläche des Targets in etwa 20 % bis 40 % der Dicke $D_1$ des Targets beträgt. Durch die geneigt verlaufende Anordnung des Targets und durch die sich daran anschließende, parallel verlaufende Targetoberfläche erhält man eine optimale Ausbildung des Targets, insbesondere wenn ein nichtferromagnetisches Metalltarget bzw. Aluminium als Beschichtungsmaterial eingesetzt wird, da durch die vorteilhafte Anordnung der Ringmagneten im Außenbereich des Targets mehr Material abgesputtert wird als im inneren Bereich. Hierdurch erhält man also eine gleichmäßige Ausnutzung des Targets.

Weitere Vorteile und Einzelheiten der Erfindung sind in den Patentansprüchen und in der Beschreibung erläutert und in den Figuren dargestellt, wobei bemerkt wird, daß alle Einzelmerkmale und alle Kombinationen von Einzelmerkmalen erfindungswesentlich sind. Es zeigt:

Fig. 1        eine Schnittdarstellung eines Targets mit mehreren konzentrisch angeordneten Ringmagneten,

Fig. 2        eine Teilansicht des Polschuhs gemäß Figur 1.

Fig. 3-7     weitere Ausführungsbeispiele von Targets mit unterschiedlich gestalteten Oberflächen.

Fig. 8        Vektoren zur Verdeutlichung der Elektronenemission.

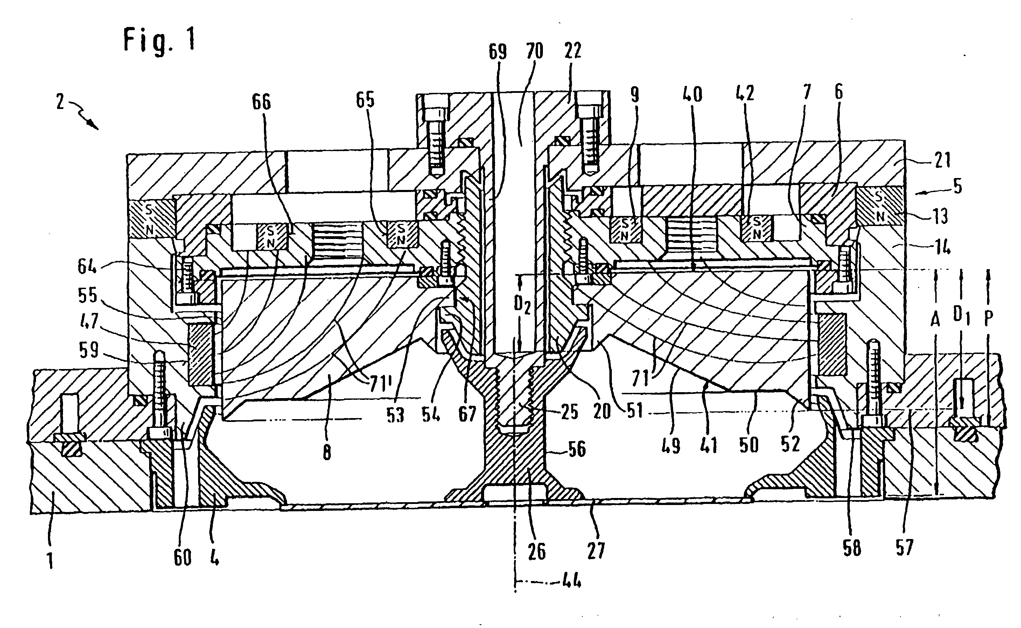

In Fig. 1 ist eine Vorrichtung zur Kathodenzerstäubung für die Herstellung von Schichten auf einem Substrat, beispielsweise einer Compact Disk 27, dargestellt. Für den Prozeßablauf kann die mit 2 bezeichnete Zerstäubungskathode in eine Kammerwand 1 der Vorrichtung zur Kathodenzerstäubung eingesetzt werden. Die Kathode besteht aus einem scheibenförmigen, ferromagnetischen Joch 5 und einer Kühlplatte 7. Zwischen dem Joch 5 und der Kühlplatte 7 ist ein Isolator 6 eingeklemmt und mittels Schraubenbolzen gesichert.

Vor der Kühlplatte 7 ist ein zu zerstäubendes Target 8 angeordnet. Auf der Rückseite der Kühlplatte 7 befindet sich ebenfalls eine ringförmige Nut 66 und eine Ringnut 65 zur Aufnahme eines inneren Ringmagneten 9 und eines äußeren Ringmagneten 42, die konzentrisch zur Mittelachse 44 des Targets 8 angeordnet sind. Das Joch 5, der Isolator 6 und die Kühlplatte 7 werden durch eine in der Zeichnung nicht dargestellte Schraube gesichert. Die Schraube ist in vorteilhafter Weise durch einen Isolator gegen das Joch isoliert. An die Schraube kann ein mit einer Sputterstrom-Versorgungseinrichtung verbundenes Kabel angeschlossen sein.

Ein weiterer konzentrisch zur Mittelachse 44 angeordneter Ringmagnet 13 befindet sich im Bereich des Außenumfangs der Kühlplatte 7 bzw. des Isolators 6. Der Magnet 13 ist ferromagnetisch ausgebildet und bildet somit den kompletten Magnetfeldeinschluß.

An den Ringmagneten 13 schließt sich ein Polschuh 14 an, der den Isolator 6, die Kühlplatte 7 sowie das Target 8 konzentrisch umgibt.

Der untere Teil des Polschuhs bildet einen pyramidenstumpfförmigen, sich nach unten bzw. in Richtung des Vakuumraums verjüngenden Polschuhteil 60. Der pyramidenstumpfförmige Polschuhteil 60 geht mit seinem Fußende in einen ringförmigen Flanschteil 61 über, der breiter ist als das freistehende Ende 62 des Polschuhs. Der Flanschteil 61 des Polschuhs 14 weist die eine Seitenwand 63 bzw. Stirnfläche auf, die Teil des sich pyramidenstumpfförmig verjüngenden Polschunteils 60 ist. Am unteren Ende des Polschuhs können zwei mit Abstand zueinander angeordnete Ringflansche 61 angebracht sein, die eine Ringkammer 59 bilden.

Ist ein vierter Ringmagnet 47 konzentrisch zur Mittelachse 44 aufgenommen, dann entfallen die Ringflansche 61.

Zwischen der Stirnseite des Endes 62 des Polschuhs 14 und der geneigt verlaufenden Seitenwand 63 des sich pyramidenstumpfförmig verjüngenden Polschuhteils 60 befindet sich ein Winkel $\alpha$, der zwischen 10° und 60° bzw.

20° und 50° bzw. 25° und 45° groß sein kann und der auf vorteilhafte Weise den Verlauf der Magnetfeldlinien beeinflußt.

Im Bereich der Mittelachse 44 der Zerstäubungskathode 2 befindet sich eine Bohrung 67, die sich durch die gesamte Vorrichtung erstreckt und die zur Aufnahme einer Hohlschraube 20 dient, die mit ihrem unteren Flanschteil 54 gegen einen am Target 8 vorgesehenen Flanschteil 53 gedrückt oder geschraubt wird.

An die Hohlschraube 20 schließt sich in axialer Richtung berührungsfrei das Joch 5 mit einer Jochplatte 21 an.

Auf der Rückseite des Jochs 5 ist ein Kühlkopf mit einem Flansch 22 befestigt, der in axialer Richtung durch die Jochplatte 21 sowie durch die Hohlschraube 20 bis zur Targetvorderseite reicht und die Hohlschraube 20 nicht berührt. Der Flansch 22 des Kühlfingers 69 mit einem sich daran anschließenden, zylinderförmigen Teil bildet eine zylinderförmige Bohrung 70 zur Aufnahme des in der Zeichnung nicht dargestellten Leitungsrohrs, das an eine Kühlwasserleitung angeschlossen ist.

An die Stirnseite bzw. an das untere Ende des Flanschs 22 des Kühlfingers 69 ist mittels einer Schraube 25 eine Mittelmaske bzw. eine Mittelanode 26 lösbar angeschlossen. Die Mittelanode reicht bis in die zentrische Vertiefung des Targets 8, welches an der Vorderseite des Targets vorgesehen ist, und bildet mit ihrem unteren Ende mit einer Außenanode 4 bzw. Außenmaske eine ringförmige Fläche für die Maskierung des Substrats 27.

Wie aus Fig. 1 hervorgeht, weist die Schraube 20 das Flanschelement 54 auf, das den am Target 8 vorgesehenen Flanschteil 53 gegen die Vorderseite der Kühlplatte 7 drückt. Auf diese Weise entfällt die sonst übliche Aufbondung des Targets, welches jederzeit leicht ausgewechselt werden kann. Ferner ist es möglich, das Target über Schrauben mit dem Kühlflansch zu verbinden.

Wie aus Fig. 1 hervorgeht, sind die beiden auf der Targetrückseite vorgesehenen Ringmagneten 9 und 42 vorzugsweise auf der gleichen Querebene angeordnet. Der innere Ringmagnet 9 ist im Bereich des Außenumfangs 56 der Mittelmaske bzw. Mittelanode 26 bzw. des Kühlfingers 69 oder näher zur Mittelachse 44 oder im Bereich des Außenumfangs der hohlförmigen Schraube 20 zur Aufnahme des Kühlfingers 69 angeordnet. Der äußere Ringmagnet 42 befindet sich im Randbereich bzw. im Bereich des Außenumfangs 55 des Targets 8.

Etwas oberhalb der beiden Ringmagneten 9 und 42 befindet sich der Ringmagnet 13, der auf dem Joch 5 angeordnet sein kann. Der Ringmagnet 13 kann aus zahlreichen einzelnen, ringförmig angeordneten Magneten gebildet sein.

Je nach Ausführung des Targets, das beispielsweise als Aluminium-Target oder als Gold-Target ausgebildet sein kann, kann ein vierter Ringmagnet 47 im Bereich des unteren Endes des Außenumfangs des Targets 8 vorgesehen sein.

Alle Ringmagneten 9, 13, 42 und 47 sind rotationssymmetrisch mit Bezug auf die Mittelachse 44 des Targets 8 angeordnet. In vorteilhafter Weise liegen auch die beiden inneren Ringmagneten 9 und 42 innerhalb des Außendurchmessers bzw. des Außenumfangs 55 des Targets 8.

Wie aus Fig. 1 hervorgeht, weist der äußere Ringmagnet 13 einen größeren Abstand zur Targetrückseite auf als die beiden inneren Ringmagneten 9 und 42.

Wird beispielsweise das Target als Aluminium-Target ausgebildet, so ist es vorteilhaft, wenn die Dicke $D_1$ des Targets 8 an seinem äußeren Randbereich größer ist als die Dicke $D_2$. Hierdurch erhält das Target 8 eine gemäß Fig. 1 geneigt verlaufende Targetoberfläche 49 und eine sich daran anschließende, parallel zur Targetrückseite verlaufende Targetoberfläche 50.

Setzt man ein Aluminium-Target ein, so wird bei Verwendung zweier Doppelringmagneten an der Rückseite des Targets auch bei sehr kompakter Bauweise das Magnetfeld abgeflacht (vgl. hierzu die Magnetfeldlinien 71 auf der rechten Seite des Targets 8). Würde man beispielsweise die beiden Doppelmagneten weglassen, so hätten die Magnetfeldlinien 71' einen sehr ungünstigen Verlauf, d. h. sie würden fast senkrecht in das Joch 5 eintreten. Auf der rechten Seite gemäß Fig. 1 haben die Feldlinien 71 einen konvexen bzw. abgeflachten oder in etwa parallelen Verlauf zur Targetrückseite. Dies wird in vorteilhafter Weise durch die beiden an der Targetrückseite vorgesehenen Doppelringmagneten 9 und 42 bewirkt, die zur Feldlinienverstärkung beitragen. Eine derartige Anordnung der Ringmagneten 9 und 42 eignet sich insbesondere bei einem nichtferromagnetischen Metalltarget, z. B. einem Aluminium-Target. Durch die doppelte Ausführung der beiden Ringmagneten wird eine sehr kompakte Bauweise der gesamten Vorrichtung erreicht und eine Kurzschlußgefahr weitgehend ausgeschlossen. Die beiden Ring- bzw. Gegenmagneten 9 und 42 verstärken also die Magnetfeldlinien, damit sie den in Fig. 1 auf der rechten Seite dargestellten Verlauf einnehmen können.

Wie aus Fig. 1 hervorgeht, ist der Abstand A zwischen der Stirnfläche der Kühlplatte 7 und der Unterkante der Mittelmaske und/oder Anode 26 größer als die Dicke $D_1$ des Targets 8 bzw. der Abstand P zwischen Targetrückseite 40 und dem spitzförmig hervorstehenden Polschuhteil 62.

Ein mittleres bzw. im Bereich der Mittelachse 44 liegendes, spitzförmiges Targetteil 51 ist mit Bezug auf das äußere Targetteil 52 zurückgesetzt.

Setzt man beispielsweise ein Target mit geringer Elektronenemissionsrate bzw. ein Gold-Target ein, so ist es vorteilhaft, wenn das Magnetfeld im Bereich der Targetoberfläche verstärkt wird, weil ein Gold-Target eine wesentlich andere Sputtereigenschaft hat als ein Aluminium-Target. Der im Bereich des Außenumfangs des Targets 8 und in den Polschuhen 14 vorgesehene Ringmagnet 47, liegt im Bereich oder auch etwas unterhalb der Targetoberfläche 41 und dient zur Verstärkung des Magnetfeldes im Bereich der Targetoberfläche 41, so daß auch bei dieser Anordnung die Magnetfeldlinien nicht senkrecht oder annähernd senkrecht in das Joch 5 eintreten. Dieser relativ große Magnet 47 liegt in Richtung des Hauptmagnetfeldes und trägt zur Verstärkung des Magnetflusses bei. In diesem Fall können die Flansche bzw. Stege 61 des Polschuhteils 62 entfallen.

Da bei Gold-Sputtering eine geringere Elektronen-Emission auftritt, wäre ohne den relativ großen Ringmagneten in der Nähe der Targetoberfläche 41 eine deutlich höhere Spannung von z. B. 2.000 V erforderlich, um eine nennenswerte Leistung zu erzielen. Durch die vorteilhafte Anbringung des Ringmagneten 47 kann das Magnetfeld verstärkt und die Plasma-Impedanz reduziert werden.

Die in Fig. 1 dargestellten Ringmagneten 9, 13, 42 sind alle gleich gepolt, wobei Norden jeweils mit Bezug auf Fig. 1 nach unten gerichtet ist.

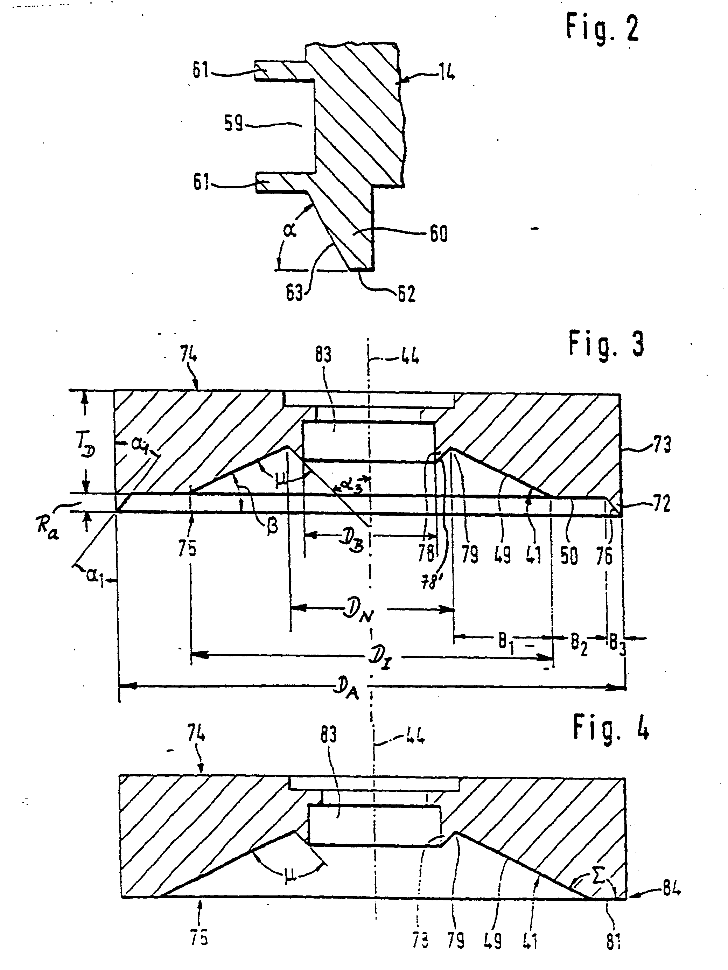

In den Figuren 3 bis 5 sind verschiedene erfindungsgemäße Zerstäubungskathoden 2 mit unterschiedlichen Targetoberflächen 41, dargestellt.

Die Magnetfeldlinien können durch die Anordnung der Ringmagnete beinflußt werden. Eine Konzentration der Magnetfeldlinien kann zum Beispiel im Bereich der Targetoberfläche durch die beiden mit Abstand zueinander angeordneten parallel verlaufenden Flansche bzw. Stege 61 (Fig. 1) erreicht werden. Ein breiter Erosionsgraben kann durch den annähernd parallelen Verlauf der Magnetfeldlinien mit Bezug auf die Fläche der Targetrückseits erreicht werden. Deshalb wäre es optimal, wenn sich das Magnetfeld der Targetoberfläche anpassen würde, um somit einen breiten Erosionsgraben zu erzielen. Hierzu ist es vorteilhaft, daß im Randbereich des Targets spitzwinklige bzw. spitzförmige Ecken bzw. Nasen 72 vorgesehen sind. Die Nasen 72 können auch einen mit Bezug auf den Querschnitt der Kathode rechteckförmigen Querschnitt aufweisen, d.h. die Seite 72 verläuft parallel zum Randteil 84 und rechtwinklig zur Targetoberfläche 82.

Die spitzförmigen Ecken bzw. Nasen 72 schließen zwischen der Targetseite 73 bzw. deren Außenumfang und der Oberfläche 76 der Nase 72 einen Winkel $\alpha_1$ ein, der in vorteilhafter Weise 40° jedoch auch zwischen 20° und 60° oder zwischen 25° und 55° oder zwischen 30° und 55° oder zwischen 38° und 54° oder auch 50° groß sein kann.

An die Nase 72 schließt sich die senkrecht zur Targetmittelachse 44 verlaufende kleine Ringfläche 50 an, die mit Bezug auf die Mittelachse 44, ebenso wie die Nase 72, die auch einen Ringteil bildet, rotationssymmetrisch angeordnet ist. Diese Ringfläche 50 liegt näher an der Targetvorderseite 75 als an der Targetrückseite 74 und geht in die schräg verlaufende Fläche 76 der Nase 72 über.

An die Ringfläche 50 schließt sich eine weitere schräg verlaufende Targetoberfläche 49 an, die zusammen mit der Nase 72 insgesamt eine annähernd konkav ausgebildete Ringfläche bildet und kurz vor der Mittelachse 44 oder einer zentrischen Bohrung 83 des Targets 2 endet.

An die geneigt verlaufende Targetoberfläche 49 schließt sich ebenfalls in Richtung der Targetvorderseite 75 eine spitzförmige Nase 78 an, die mit ihrem Targetflächenabschnitt 78' und der nach innen geneigt verlaufenden Targetoberfläche 49 eine V-förmige rotationssymmetrische Ringnut 79 bildet, die einen Winkel $\mu$ von vorzugsweise über 90°, vorzugsweise 125° einschließt. Ein Konuswinkel $\alpha_3$ des Targetflächenaßschnitts 78' zur Mittelachse 44 beträgt 10 bis 80°, vorzugsweise 20° bis 70°, weiter bevorzugt 30° bis 60° und besonders bevorzugt 60°.

Wie aus Fig. 3 hervorgeht, weist der Randteil mit der Nase 72 eine Breite $B_3$ auf, die kleiner ist als die Breite $B_2$ der Ringfläche bzw. als die Breite $B_1$ der geneigt verlaufenden Fläche 49.

Die Breite $B_1$ ist in etwa doppelt so groß wie die Breite $B_2$ und doppelt so groß wie die Breite $B_3$.

Der Winkel $\beta$ zwischen der geneigt verlaufenden Oberfläche 49 und der Targetvorderseite 75 ist in etwa zwischen 18° und 34° oder zwischen 20° und 32° oder zwischen 23° und 29° oder auch 26° groß.

Die innere Spitze der V-förmigen Ringnut 79 liegt in etwa in der Mitte zwischen der Targetrückseite 74 und der Targetvorderseite 75.

Ein besonders bevorzugtes Target hat die folgenden Abmessungen (vgl. Fig. 3):

$$\text{Targetdicke (ohne Außenrand 72) } T_D = 30 \pm 5 \text{ mm}$$

(Abstand Targetrückseite - ebene Targetfläche 50)

Durchmesser der Grenzlinie zwischen den Targetflächenabschnitten 49 und 50: $D_I = 102 \pm 5$ mm

Konuswinkel des Targetflächenabschnitts 49: $\beta = 25° \pm 5°$ dazu bevorzugt sind noch folgende Abmessungen:

| | |
|---|---|
| Außendurchmesser des Targets | $D_A = 150 \pm 5$ mm |
| Konuswinkel des Außenrandes | $\alpha_1 = 50° \pm 5°$ |
| Randüberhöhung (außen) | $R_a = 3,8 \pm 0,2$ mm |

(fortgesetzt)

| Nutdurchmesser (Nut 79) | $D_N$ = 47,8 $\pm$ 0,5 mm |
|---|---|
| Nutwinkel (Nut 79) | $\mu$ = 125° $\pm$ 5° |
| Mittelbohrung | Durchmesser $D_B$ = 40 $\pm$ 2 mm |

Anstelle des in etwa stufenförmigen Verlaufs der Targetvorderseite bzw. Targetoberfläche 76, 50, 49 kann auch auf die äußere Nase 72 gemäß Fig. 3 verzichtet werden und eine parallel zur Targetrückseite 74 verlaufende, kleine Targetoberfläche 81 vorgesehen sein, die am einen Ende an einen Außenumfang bzw. Randteil 84 und am anderen Ende an die schrägverlaufende Targetoberfläche 49 angrenzt und mit dieser einen Winkel E zwischen 120° und 160° einschließt.

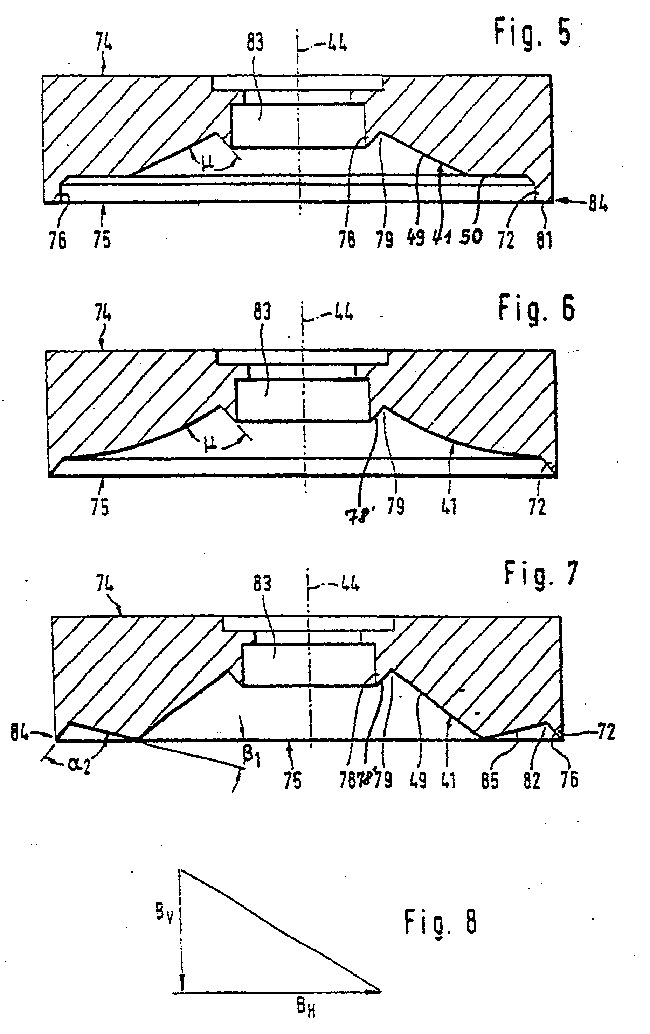

Gemäß Fig. 7 können die Targetoberflächen 49, 85, 76 auch einen zick-zack-förmigen Verlauf aufweisen; d. h. die innen, im Bereich der Bohrung 83 des Targets liegende Oberfläche 78' bildet die erste Ringnut 79 mit der Targetoberfläche 49, daran schließt sich die geneigt verlaufende Targetoberfläche 49 und daran eine zweite Ringnut 82, die durch die Flächen 76, 85 gebildet wird. Diese Flächen 76, 85 schließen den Winkel $\alpha_2$ ein, der zwischen 70° und 175° groß sein kann, und/oder den Winkel $\beta_1$, der zwischen 5° und 50° bzw. 5° und 20° oder zwischen 8° und 12° groß sein kann.

Ferner ist es gemäß Fig. 5 möglich, daß die geneigt verlaufende Targetoberfläche 49 zwischen den beiden Nasen 78 und 72 konvex oder konkav verläuft. Das kreisrunde Target kann auch oval bzw. länglich ausgebildet sein, wobei die Kreisbögen durch parallel verlaufende Targetwände verbunden werden. Durch die spitzwinkligen oder rechteckförmigen Nasen 72 und 78 werden wie aus Fig. 8 hervorgeht, die Elektronen abgelenkt und zwar im rechten Winkel (vgl. die Vektoren $B_H$ $B_V$ an der Magnetfeldlinie in Fig. 8). Die horizontale Komponente $B_H$ hält die Elektronen auf der Targetoberfläche und die vertikale Komponente $B_V$ die Elektronen in seitlicher Richtung. Die Vektoren in Fig. 8 zeigen also, wie groß der Anteil der Elektronen ist, die auf der Targetoberfläche fokussiert bzw. welche Elektronen auf das Target zurückbeschleunigt werden.

Bezugszeichenliste

1    Rammerwand
2    Zerstäubungskathode
4    Anode
5    Joch
6    Isolator
7    Kühlplatte
8    Target
9    Ringmagnet
9'   Ringmagnet
9"   Ringmagnet
9'''  Ringmagnet
10   Schraube
11   Kabel
12   Isolator
13   Ringmagnet
14   Polschuh
15   Kühlring, -körper
16   Kühlkanal
17   Schraube
18   Kühlwasseranschluß
19   Kühlwasseranschluß
20   Hohlschraube, Polschuh (Befestigungsvorrichtung)
21   Jochplatte
22   Flansch des Kühlfingers
23   Kühlwasserleitung
24   Kühlwasserleitung
25   Schraube

| | |
|---|---|
| 26 | Mittelmaske bzw. Mittelanode |
| 27 | Substrat |
| 28 | Nut |
| 29 | Ausnehmung |
| 30 | Kammeroberfläche |
| 31 | Unterseite |
| 32 | Klemmring |
| 33 | Anodenring |
| 40 | Targetrückseite |
| 41 | Oberfläche des Targets |
| 42 | Ringmagnet |
| 43 | Randbereich bzw. Außenumfang |
| 44 | Mittelachse |
| 47 | vierter Ringmagnet |
| 48 | Außenumfang |
| 49 | geneigt verlaufende Targetoberfläche |
| 50 | parallel verlaufende Targetoberfläche |
| 51 | spitzförmig hervorstehendes Targetteil |
| 52 | spitzförmig hervorstehendes Targetteil |
| 53 | Flanschteil |
| 54 | Flanschteil der Schraube |
| 55 | Außenumfang des Targets (8) |
| 56 | Außenumfang der Mittelmaske (26) |
| 57 | untere Begrenzung der Targetoberfläche |
| 58 | unterhalb der unteren Begrenzung des Polschuhs 14 |
| 59 | im unteren Bereich des Polschuhs (14), Ringraum bzw. Kammer |
| 60 | pyramidenstumpfförmig sich verjüngender Polschuhteil |
| 61 | Flanschteil des Polschuhteils bzw. Stege |
| 62 | freistehendes Ende des Polschuhs |
| 63 | Seitenwand des pyramidenstumpfförmig sich verjüngenden Polschuhteils (60) |
| 64 | Schraubenbolzen |
| 65 | Ringnut |
| 66 | Ringnut |
| 67 | Bohrung |
| 68 | Axialbohrung |
| 69 | Kühlfinger |
| 70 | Bohrung |
| 71 | Magnetfeldlinien |
| 71' | Magnetfeldlinien |
| $D_1$ | Dicke des Targets (8), außen |
| $D_2$ | Dicke des Targets (8), innen |
| A | Abstand 7 - 26 |
| P | Abstand 40 - 62 |

**Patentansprüche**

1. Target für eine Kathodenzerstäubungsvorrichtung, bestehend aus einem ringförmigen Körper mit einer äußeren Zylindermantelfläche (43), einer zur Mittelachse (44) senkrechten Targetrückseite (40; 74) und einer konkaven Targetoberfläche (41) als Targetneufläche, wobei die zur Mittelachse rotationssymmetrische Targetoberfläche (41) aufweist:

(a) einen kegelförmigen Targetflächenabschnitt (49), der gegenüber einer zur Mittelachse (44) senkrechten Ebene (75) um einen Winkel nach innen geneigt ist und

(b) einen inneren Randabschnitt (51; 78), dessen kegelstumpfförmige Oberfläche (78') gegenüber der Mittelachse um einen Winkel $\alpha_3$ nach außen geneigt ist und der zur Ausbildung einer im wesentlichen V-förmigen Nut (79) an den kegelförmigen Targetflächenabschnitt (49) angrenzt, wobei der kegelförmige Targetflächenabschnitt (49) in einen radial außen liegenden, zur Mittelachse (44) senkrechten Targetflächenabschnitt (50; 81) übergeht.

2. Target nach Anspruch 1, wobei der zur Mittelachse (44) senkrechte Targetflächenabschnitt (50) in einen radial außen liegenden, kegelförmigen Randbereich (52; 76) übergeht, dessen Kegelfläche zur Mittelachse (44) um einen Winkel $\alpha_1$ geneigt ist.

3. Target nach Anspruch 1 oder 2, wobei der Konuswinkel $\alpha_3$ des inneren Targetoberflächenabschnitts (78') zur Mittelachse (44) von 10° bis 80°, vorzugsweise von 20° bis 70°, weiter bevorzugt von 30° bis 60° und besonders bevorzugt 60° beträgt.

4. Target nach Anspruch 1, 2 oder 3, wobei der Konuswinkel $\beta$ des sich an den inneren Targetoberflächenabschnitts (78') nach radial außen anschließenden Targetoberflächenabschnitts (49), bezogen auf die zur Mittelachse (44) senkrechte Ebene der Targetvorderseite (75), von 15° bis 35°, vorzugsweise von 20° bis 32°, weiter bevorzugt von 23° bis 29° und besonders bevorzugt 25° beträgt.

5. Target nach einem der Ansprüche 1 bis 4, wobei die Targetoberfläche (41) im Bereich des radial äußeren Randes durch einen gegenüber der Mittelachse (44) geneigten, axial vorstehenden Randvorsprung (52; 72) begrenzt ist.

6. Target nach einem der Ansprüche 2 bis 5, wobei der Konuswinkel $\alpha_1$ des Randbereichs (76) von 20° bis 60°, vorzugsweise von 25° bis 55°, weiter bevorzugt von 30° bis 55° oder 38° bis 54° und besonders bevorzugt 50° beträgt.

7. Target nach einem der Ansprüche 1 bis 6, wobei die Targetoberfläche (49) mit dem zur Mittelachse (44) senkrechten Targetflächenabschnitt (50; 81) einen Winkel $\Sigma$ von 120° bis 160° einschließt.

8. Target nach einem der Ansprüche 1 bis 7, wobei die V-förmige Ringnut (79) einen Winkel $\mu$ von vorzugsweise über 90°, vorzugsweise von 125° einschließt.

9. Target nach einem der Ansprüche 5 bis 8, wobei die Breite $B_3$ des Randvorsprungs (72) kleiner ist als die Breite $B_2$ der zur Mittelachse senkrechten Ringfläche des Targetflächenabschnitts (50) und kleiner ist als die Breite $B_1$ des geneigten Targetoberflächenabschnitts (49).

10. Target nach Anspruch 9, **dadurch gekennzeichnet, daß** die Breite $B_1$ etwa doppelt so groß wie die Breite $B_2$ und doppelt so groß wie die Breite $B_3$ ist.

11. Target nach einem der Ansprüche 1 bis 10, wobei die Dikke $D_1$ des Targets (8) an seinem äußeren Randbereich grösser ist als die Dicke $D_2$ im inneren Randbereich des Targets (8).

12. Vorrichtung zur Kathodenzerstäubung für die Herstellung von Schichten auf einem Substrat (27) mittels einer in eine Vakuumkammer einbringbaren Zerstäubungskathode (2) mit einem Target nach einem der Ansprüche 1 bis 11, wobei im Bereich des Außenumfangs (55) des Targets (8) mindestens ein Ringmagnet (47) unterhalb, d. h. in Richtung auf das Substrat (27), der an der Targetrückseite (40) bzw. in deren Bereich vorgesehenen Ringmagneten (9 bzw. 13) zugeordnet ist.

13. Vorrichtung nach Anspruch 12, wobei der im Bereich des Außenumfangs (55) des Targets (8) vorgesehene Ringmagnet (47) etwas oberhalb, d. h. in entgegengesetzter Richtung zum Substrat (27), oder etwas unterhalb oder außerhalb der unteren Begrenzung (57) der Targetoberfläche (50; 81) vorgesehen ist.

14. Vorrichtung nach Anspruch 12 oder 13, wobei der im Bereich des Außenumfangs (55) des Targets (8) vorgesehene Ringmagnet (47) etwas unterhalb oder außerhalb der unteren Begrenzung (58) von Polschuhen (14) endet.

15. Vorrichtung nach einem der Ansprüche 12 bis 14, wobei der Ringmagnet (47) konzentrisch zur Mittelachse (44) des Targets (8) angeordnet ist.

16. Vorrichtung nach Anspruch 14 oder 15, **dadurch gekennzeichnet, daß** das untere Ende (58) des Polschuhs (14) einen größeren Abstand P zur Targetrückseite (40) aufweist als das untere Ende (62) des Targets bzw. die Targetoberfläche (50).

**17.** Vorrichtung nach einem der Ansprüche 14 bis 16, wobei im unteren Bereich des Polschuhs (14) ein Ringraum bzw. eine Kammer (59) bzw. zwei mit Abstand angeordnete Flansche oder Stege (61) vorgesehen sind.

**18.** Vorrichtung nach einem der Ansprüche 14 bis 17, wobei der untere Teil des Polschuhs (14) zum Außenumfang der Polschuhe (14) aus einem sich pyramidenstumpfförmig verjüngenden Folschuhteil (60) besteht.

**19.** Vorrichtung nach einem der Ansprüche 14 bis 18, wobei der sich pyramidenstumpfförmig verjüngende Polschuhteil (60) in den Flanschteil (61) übergeht, der breiter ist als das freistehende Ende (62) des Polschuhs (14).

**20.** Vorrichtung nach einem der Ansprüche 14 bis 19, wobei die Flanschteile (61) des Polschuhs (14) parallel zur Targetrückseite (40) verlaufen.

**21.** Vorrichtung nach einem der Ansprüche 14 bis 20, wobei zwischen der Stirnfläche des Endes (62) des Polschuhs (14) und der geneigt verlaufenden Seitenwand bzw. Stirnfläche (63) des sich pyramidenstumpfförmig verjüngenden Polschuhteils (60) ein Winkel $\alpha$ eingeschlossen ist, der zwischen 10° und 50° bzw. zwischen 25° und 45° groß ist.

**22.** Vorrichtung nach einem der Ansprüche 14 bis 21 mit einem Target nach einem der Ansprüche 2 bis 11, wobei die Oberfläche bzw. Ringfläche (63) des Polschuhteils (60) auf der gleichen geneigten Ebene liegt wie der radial außen liegende Randbereich (52; 76).

**23.** Vorrichtung nach einem der Ansprüche 12 bis 22, wobei im Bereich der Targetrückseite (40; 74) ein erster innerer Ringmagnet (9) und ein zweiter äußerer, im Durchmesser größerer Ringmagnet (42) vorgesehen sind.

**24.** Vorrichtung nach Anspruch 23, wobei die beiden im Bereich der Targetrückseite vorgesehenen Ringmagneten (9; 42) auf der gleichen Querebene angeordnet sind.

**25.** Vorrichtung nach Anspruch 23 oder 24, wobei der innere Ringmagnet (9) im Bereich des Außenumfangs (56) einer Mittelmaske bzw. Mittelanode (26) bzw. eines Kühlfingers und der äußere Ringmagnet (42) im Randbereich bzw. im Bereich des Außenumfangs (55) des Targets (8) vorgesehen ist.

**26.** Vorrichtung nach einem der Ansprüche 23 bis 25, wobei neben den beiden Ringmagneten (9; 42) ein dritter, die beiden Ringmagneten (9; 42) umgebender Ringmagnet (13) vorgesehen ist.

**27.** Vorrichtung nach Anspruch 26, **dadurch gekennzeichnet, daß** der dritte Ringmagnet (13) an eine Seite bzw. an die untere Seite des Joches (5) angrenzt.

**28.** Vorrichtung nach einem der Ansprüche 23 bis 27, wobei alle Ringmagneten (9; 13; 42) rotationssymmetrisch mit Bezug auf die Mittelachse (44) des Targets angeordnet sind.

**29.** Vorrichtung nach einem der Ansprüche 26 bis 28, wobei die beiden Ringmagneten (9; 42) in sich in einer Kühlplatte (7) befindenden Ringnuten (65, 66) vorgesehen sind.

**30.** Vorrichtung nach einem der Ansprüche 26 bis 29, wobei der dritte Ringmagnet (13) im Bereich des Polschuh-Durchmessers zwischen einem Joch (5) und einem oberen Teil eines Polschuhs (14) vorgesehen ist.

**31.** Vorrichtung nach einem der Ansprüche 23 bis 30, wobei die beiden Ringmagneten (9; 42) innerhalb des Außendurchmessers bzw. des Außenumfangs (55) des Targets (8) liegen.

**32.** Vorrichtung nach einem der Ansprüche 26 bis 32, wobei der Ringmagnet (13) einen größeren Abstand zur Targetrückseite (40) aufweist als die beiden Ringmagneten (9; 42).

**33.** Vorrichtung nach einem der Ansprüche 26 bis 32, mit einem vierten Ringmagneten (47), der den Außenumfang (55) des Targets (8) umgibt.

**34.** Vorrichtung nach einem der Ansprüche 12 bis 33, wobei am inneren Randbereich des Targets (8) ein ringförmiges, konzentrisch zur Mittelachse (44) verlaufendes Flanschteil (53) vorgesehen ist, das zwischen der Oberfläche einer/der Kühlplatte (7) und dem Flanschteil (54) einer Befestigungsvorrichtung (20) eingeklemmt ist, die mit dem Target (8) fest bzw. lösbar verbunden ist.

**Claims**

1.  A target for a cathode sputtering device consisting of an annular body having an exterior cylinder surface area (43), a back surface (40; 74) of the target extending vertically with respect to the center axis (44) and a concave target surface (41) as a new target surface, wherein the target surface (41) being axially symmetrical with respect to the center axis comprises:

    (a) a conical target surface portion (49) which is inclined inwardly by an angle with respect to a plane (75) extending vertically with respect to the center axis (44) and

    (b) an inner edge portion (51; 78) whose surface (78') having the shape of a truncated cone is inclined outwardly by an angle $\alpha_3$ with respect to the center axis and which adjoins the conical target surface portion (49) in order to form an essentially V-shaped groove (79), wherein the conical target surface portion (49) makes a transition into a target surface portion (50; 81) extending radially at the outer surface and vertically with respect to the center axis (44).

2.  The target according to claim 1, wherein the target surface portion (50) extending vertically with respect to the center axis (44) makes a transition into a conical edge portion (52; 76) extending radially at the outer surface, the cone surface of said edge portion (52; 76) being inclined by an angle $\alpha_1$ with respect to the center axis (44).

3.  The target according to claim 1 or 2, wherein the cone angle $\alpha_3$ between the inner target surface portion (78') and the center axis (44) has a value between 10° and 80°, preferably between 20° and 70°, more preferably between 30° and 60°, and most preferably of 60°.

4.  The target according to claim 1, 2 or 3, wherein relative to the plane of the front surface (75) of the target extending vertically with respect to the center axis (44), the cone angle β of the target surface portion (49) radially outwardly adjoining the inner target surface portion (78') has a value of 15° to 35°, preferably 20° to 32°, more preferably 23° to 29° and most preferably of 25°.

5.  The target according to any one of claims 1 to 4, wherein in the area of the radially outer edge, the target surface (41) is delimited by an axially projecting edge projection (52; 72) being inclined with respect to the center axis (44).

6.  The target according to any one of claims 2 to 5, wherein the cone angle $\alpha_1$ of the edge portion (76) has a value between 20° and 60°, preferably between 25° and 55°, more preferably between 30° and 55° or 38° and 54°, and particularly preferably of 50°.

7.  The target according to any one of claims 1 to 6, wherein the target surface (49) and the target surface portion (50; 81) being vertical with respect to the center axis (44) form an angle Σ having a value between 120° and 160°.

8.  The target according to any one of claims 1 to 7, wherein the V-shaped annular groove (79) encloses an angle μ of preferably more than 90°, preferably 125°.

9.  The target according to any one of claims 5 to 8, wherein the width $B_3$ of the projecting edge (72) is smaller than the width $B_2$ of the annular surface of the target surface intermediate portion (50) extending vertically with respect to the center axis, and smaller than the width $B_1$ of the inclined target surface portion (49).

10. The target according to claim 9, **characterized in that** the width $B_1$ is approximately twice as large as the width $B_2$, and twice as large as the width $B_3$.

11. The target according to any one of claims 1 to 10, wherein the thickness $D_1$ of the target (8) at its outer edge area is greater than the thickness $D_2$ of the target (8) at its inner edge area.

12. A cathode sputtering device for producing coatings on a substrate (27) by means of a sputtering cathode (2), which can be introduced into a vacuum chamber, comprising a target according to any one of claims 1 to 11, wherein in the area of the exterior circumference (55) of the target (8) at least one ring magnet (47) is provided below, i.e. in the direction towards the substrate (27), the ring magnets (9 or 13) located on the back surface (40) of the target or in its area.

13. The device according to claim 12, wherein the ring magnet (47) provided in the area of the exterior circumference (55) of the target (8) is located slightly above, i.e. in the opposite direction with respect to the substrate (27), or slightly below or outside the lower limit (57) of the target surface (50; 81).

14. The device according to claim 12 or 13, wherein the ring magnet (47) provided in the area of the exterior circumference (55) of the target (8) ends slightly below or outside the lower limit (58) of the pole shoes (14).

15. The device according to any one of claims 12 to 14, wherein the ring magnet (47) extends concentrically with the center axis (44) of the target (8).

16. The device according to claim 14 or 15, **characterized in that** the lower end (58) of the pole shoe (14) is at a greater distance P from the back surface (40) of the target than the lower end (62) of the target or the target surface (50).

17. The device according to any one of claims 14 to 16, wherein in the lower area of the pole shoe (14) an annular space or chamber (59) or two spaced apart flanges or bars (61) are provided.

18. The device according to any one of claims 14 to 17, wherein the lower portion of the pole shoe (14) extending to the exterior circumference of the pole shoes (14) consists of a pole shoe element (60) which tapers in the form of a truncated pyramid.

19. The device according to any one of claims 14 to 18, wherein the pole shoe element (60) which tapers in the form of a truncated pyramid makes a transition into the flange element (61) which is wider than the free-standing end (62) of the pole shoe (14).

20. The device according to any one of claims 14 to 19, wherein the flange elements (61) of the pole shoe (14) extend parallel with the back surface (40) of the target.

21. The device according to any one of claims 14 to 20, wherein an angle $\alpha$ is enclosed between the front face of the end (62) of the pole shoe (14) and the inclined lateral wall or front face (63) of the pole shoe element (60) which tapers in the form of a truncated pyramid, said angle $\alpha$ having a value between 10° and 50° or between 25° and 45°.

22. The device according to any one of claims 14 to 21 comprising a target according to any one of claims 2 to 11, wherein the surface or annular surface (63) of the pole shoe element (60) is located on the same inclined plane as the edge area (52; 76) extending radially at the outer surface.

23. The device according to any one of claims 12 to 22, wherein in the area of the back surface (40; 74) of the target a first inner ring magnet (9) and a second outer ring magnet (42) having a larger diameter are provided.

24. The device according to claim 23, wherein the two ring magnets (9, 42) provided in the area of the back surface of the target are arranged on the same transverse plane.

25. The device according to claim 23 or 24, wherein the inner ring magnet (9) is provided in the area of the exterior circumference (56) of a center mask or center anode (26), or a cooling finger, and the outer ring magnet (42) is provided in the edge area or in the area of the exterior circumference (55) of the target (8).

26. The device according to any one of claims 23 to 25, wherein a third ring magnet (13), which surrounds the two ring magnets (9, 42), is provided besides the two inner ring magnets (9, 42).

27. The device according to claim 26, **characterized in that** the third ring magnet (13) adjoins a side or the lower side of the yoke (5).

28. The device according to any one of claims 23 to 27, wherein all ring magnets (9; 13; 42) are mounted to be axially symmetrical with respect to the center axis (44) of the target.

**29.** The device according to any one of claims 26 to 28, wherein the two ring magnets (9, 42) are arranged in annular grooves (65, 66) provided in the cooling plate (7).

**30.** The device according to any one of claims 26 to 29, wherein the third ring magnet (13) is provided in the area of the pole shoe diameter between a yoke (5) and an upper portion of the pole shoe (14).

**31.** The device according to any one of claims 23 to 30, wherein the two ring magnets (9; 42) are located inside the external diameter or the external circumference (55) of the target (8).

**32.** The device according to any one of claims 26 to 32, wherein the ring magnet (13) is at a larger distance from the back surface (40) of the target than the two ring magnets (9; 42).

**33.** The device according to any one of claims 26 to 32 comprising a fourth ring magnet (47) which surrounds the exterior circumference (55) of the target (8).

**34.** The device according to any one of claims 12 to 33, wherein an annular flange element (53) extending concentrically with the center axis (44) is provided at the inner edge of the target (8), said annular flange element (53) being clamped between a/the surface of the cooling plate (7) and the flange element (54) of a fastening device (20) being fixedly or releasably connected with the target (8).

## Revendications

**1.** Cible pour dispositif de pulvérisation cathodique, constituée d'un corps de forme annulaire comportant une surface d'enveloppe extérieure cylindrique (43), une face d'envers de cible (40 ; 74) perpendiculaire à l'axe médian (44) et une surface de cible concave (41) servant de nouvelle surface de cible, la surface de cible (41) symétrique en rotation par rapport à l'axe médian comprenant :

(a) une section conique (49) de surface de cible qui est inclinée vers l'intérieur d'un certain angle par rapport à un plan (75) perpendiculaire à l'axe médian (44) et
(b) une section de bord intérieure (51 ; 78) dont la surface (78') de forme tronconique est inclinée vers l'extérieur d'un angle $\alpha_3$ par rapport à l'axe médian et qui est contiguë à la section conique (49) de surface de cible, en vue de la formation d'une gorge (79) sensiblement en forme de V, la section conique (49) de surface de cible donnant sur une section de surface de cible (50 ; 81), qui est située radialement à l'extérieur et qui est perpendiculaire à l'axe médian (44).

**2.** Cible selon la revendication 1, dans laquelle la section de surface de cible (50) perpendiculaire à l'axe médian (44) donne sur une zone de bord conique (52 ; 76), située radialement à l'extérieur, dont la surface conique est inclinée d'un angle $\alpha_1$ par rapport à l'axe médian (44).

**3.** Cible selon la revendication 1 ou 2, dans laquelle l'angle de cône $\alpha_3$ de la section intérieure (78') de surface de cible est de 10° à 80° par rapport à l'axe médian (44), de préférence de 20° à 70°, plus préférentiellement 30° à 60° et particulièrement préférentiellement de 60°.

**4.** Cible selon la revendication 1, 2 ou 3, dans laquelle l'angle de cône $\beta$ de la section (49) de surface de cible qui se rattache radialement vers l'extérieur à la section intérieure (78') de surface de cible est de 15° à 35° par rapport au plan de la face avant (75) de la cible perpendiculaire à l'axe médian (44), de préférence de 20° à 32°, plus préférentiellement de 23° à 29° et particulièrement préférentiellement de 25°.

**5.** Cible selon l'une des revendications 1 à 4, dans laquelle la surface de cible (41) est limitée dans la zone du bord radialement extérieur, par une proéminence de bord (52 ; 72) qui fait saillie axialement et qui est inclinée par rapport à l'axe médian (44).

**6.** Cible selon une des revendications 2 à 5, dans laquelle l'angle de cône $\alpha_1$ de la zone de bord (76) est de 20° à 60°, de préférence de 25° à 55°, plus préférentiellement de 30° à 55° ou de 38° à 54° et particulièrement préférentiellement de 50°.

**7.** Cible selon une des revendications 1 à 6, dans laquelle la surface de cible (49) et la section (50 ; 81) de surface de cible perpendiculaire à l'axe médian (44) forment entre elles un angle $\Sigma$ de 120° à 160°.

8. Cible selon les revendications 1 à 7, dans laquelle la gorge annulaire (79) en forme de V forme un angle $\mu$ de préférence supérieur à 90°, de préférence de 125°.

9. Cible selon les revendications 5 à 8, dans laquelle la largeur $B_3$ de la proéminence de bord (72) est inférieure à la largeur $B_2$ de la surface annulaire, perpendiculaire à l'axe médian, de la section (50) de surface de cible et inférieure à la largeur $B_1$ de la section inclinée (49) de surface de cible.

10. Cible selon la revendication 9, **caractérisée en ce que** la largeur $B_1$ est approximativement deux fois plus grande que la largeur $B_2$ et deux fois plus grande que la largeur $B_3$.

11. Cible selon l'une des revendications 1 à 10, dans laquelle l'épaisseur $D_1$ de la cible (8) sur sa zone de bord extérieure est supérieure à l'épaisseur $D_2$, dans la zone de bord intérieure de la cible (8).

12. Dispositif de pulvérisation cathodique destiné à la réalisation de couches sur un substrat (27) au moyen d'une cathode de pulvérisation (2), susceptible d'être introduite dans une enceinte sous vide, comportant une cible selon une des revendications 1 à 11, au moins un aimant annulaire (47) étant disposé, dans la zone périphérique extérieure (55) de la cible (8), en-dessous, c'est-à-dire en direction du substrat (27), des aimants annulaires (9 ou 13) prévus sur la face arrière (40) de la cible ou dans la zone de celle-ci.

13. Dispositif selon la revendication 12, dans lequel l'aimant annulaire (47) prévu dans la zone périphérique extérieure (55) de la cible (8) est disposé quelque peu au-dessus, c'est-à-dire dans la direction opposée à celle du substrat (27), ou quelque peu en dessous ou à l'extérieur de la limite inférieure (57) de la surface (50 ; 81) de la cible.

14. Dispositif selon la revendication 12 ou 13, dans lequel l'aimant annulaire (47) prévu dans la zone périphérique extérieure (55) de la cible (8) se termine quelque peu en dessous ou à l'extérieur de la limite inférieure (58) de pièces polaires (14).

15. Dispositif selon l'une des revendications 12 à 14, dans lequel l'aimant annulaire (47) est disposé concentriquement à l'axe médian (44) de la cible (8).

16. Dispositif selon la revendication 14 ou 15, **caractérisé en ce que** l'extrémité inférieure (58) de la pièce polaire (14) présente un plus grand écart P par rapport à la face d'envers (40) de la cible que l'extrémité inférieure (62) de la cible, ou de la surface (50) de la cible.

17. Dispositif selon une des revendications 14 à 16, dans lequel sont prévus un espace annulaire, ou bien une chambre (59), ou bien deux collets ou nervures (61) disposés avec un écart entre eux dans la zone inférieure des pièces polaires.

18. Dispositif selon l'une des revendications 14 à 17, dans lequel la partie inférieure de la pièce polaire (14) en direction de la périphérie extérieure des pièces polaires (14) est constituée d'une partie de pièce polaire (60) qui se rétrécit en forme de tronc de pyramide.

19. Dispositif selon une des revendications 14 à 18, dans lequel la partie (60) de pièce polaire, qui se rétrécit en forme de tronc de pyramide, donne sur la partie de collet (61) qui est plus large que l'extrémité libre (62) de la pièce polaire (14).

20. Dispositif selon une des revendications 14 à 19, dans lequel les parties de collets (61) de la pièce polaire (14) s'étendent parallèlement à la face d'envers (40) de la cible.

21. Dispositif selon une des revendications 14 à 20, dans lequel la surface frontale de l'extrémité (62) de la pièce polaire (14) et la paroi latérale s'étendant de façon inclinée, ou surface frontale (63), de la partie (60) de pièce polaire qui se rétrécit en forme de tronc de pyramide, forment entre elles un angle $\alpha$ qui est compris entre 10° et 50°, ou entre 25° et 45°.

22. Dispositif selon une des revendications 14 à 21 comportant une cible selon une des revendications 2 à 11, dans lequel 1a surface, ou la surface annulaire (63) de la pièce polaire (60), se situe dans le même plan incliné que la zone de bord (52 ; 76) située radialement à l'extérieur.

23. Dispositif selon une des revendications 12 à 22, dans lequel sont prévus, dans la zone de la face d'envers (40 ; 74) de la cible, un premier aimant annulaire intérieur (9) et un deuxième aimant annulaire extérieur (42) d'un plus grand diamètre.

24. Dispositif selon la revendication 23, dans lequel les deux aimants annulaires (9 ; 42) prévus dans la zone de la face d'envers de la cible, sont disposés dans le même plan transversal.

25. Dispositif selon la revendication 23 ou 24, dans lequel l'aimant annulaire intérieur (9) est prévu dans la zone périphérique extérieure (56) d'un masque médian ou d'une anode médiane (26), ou d'un doigt de refroidissement et dans lequel l'aimant annulaire extérieur (42) est prévu dans la zone de bord ou dans la zone de périmètre extérieur (55) de la cible (8).

26. Dispositif selon une des revendications 23 à 25, dans lequel, en plus des deux aimants annulaires (9 ; 42), est prévu un troisième aimant annulaire (13) qui entoure les deux aimants annulaires (9 ; 42).

27. Dispositif selon la revendication 26, **caractérisé en ce que** le troisième aimant annulaire (13) est contigu à un côté, ou contigu au côté inférieur, de la culasse (5).

28. Dispositif selon une des revendications 23 à 27, dans lequel tous les aimants annulaires (9 ; 13 ; 42) sont disposés de façon symétrique en rotation par rapport à l'axe médian (44) de la cible.

29. Dispositif selon une des revendications 26 à 28, dans lequel les deux aimants annulaires (9 ; 42) sont prévus dans des gorges annulaires (65, 66) qui se trouvent dans une plaque de refroidissement (7).

30. Dispositif selon une des revendications 26 à 29, dans lequel le troisième aimant annulaire (13) est prévu dans la zone du diamètre de la pièce polaire entre une culasse (5) et une partie supérieure -d'une pièce polaire (14).

31. Dispositif selon une des revendications 23 à 30, dans lequel les deux aimants annulaires (9 ; 42) sont situés à l'intérieur du diamètre extérieur ou du périmètre extérieur (55) de la cible (8).

32. Dispositif selon une des revendications 26 à 32, dans lequel l'aimant annulaire (13) présente un plus grand écart par rapport à la face d'envers (40) de la cible que les deux aimants annulaires (9 ; 42).

33. Dispositif selon une des revendications 26 à 32, comportant un quatrième aimant annulaire (47) qui entoure le périmètre extérieur (55) de la cible (8).

34. Dispositif selon une des revendications 12 à 33, dans lequel est prévue, sur la zone de bord intérieure de la cible (8), une pièce formant collet annulaire (53) qui s'étend concentriquement à l'axe médian (44) et qui est enserrée entre la surface d'une/de la plaque de refroidissement (7) et la pièce formant collet (54) d'un dispositif de fixation (20), qui est relié à la cible (8) de façon fixe ou libérable.

Fig. 1

Fig. 2

Fig. 3

Fig. 4

Fig. 5

Fig. 6

Fig. 7

Fig. 8